# EUROPEAN PATENT APPLICATION

(11) **EP 2 511 230 A1**
(43) Date of publication of application: **17.10.2012**
(21) Application number: 12163523.9
(22) Date of filing: 10.04.2012
(51) Int. Cl.: B81C 1/00

(54) **A method for sealing a micro-cavity**

(30) Priority: 11.04.2011 US 201161474014 P
(71) Applicant: IMEC, 3001 Leuven (BE)
(72) Inventor: Helin, Philippe, 3001 Leuven (BE)
(74) Representative: Sarlet, Steven Renaat Irène

(57) **Abstract**

The present invention is related to a method for sealing a cavity, preferably a cavity wherein a MEMS or NEMS device is located. According to the method, a membrane layer is deposited on top of a sacrificial layer, after which release holes are etched in the membrane layer and a release step is performed wherein at least a portion of the sacrificial layer is removed through the release holes, to thereby form the cavity. Before said release step, a narrowing layer is produced on the side walls of the release holes. The narrowing layer can be a sealing layer which seals off the release holes after a reflow step. Alternatively, the narrowing layer can be a layer that does not have a sealing function, but which is aimed only at narrowing the holes, so as to be able to seal off the holes without the danger of sealing or other material entering the cavity. The narrowing layer may be deposited by conformal deposition followed by an anisotropic etch, or by direct deposition on the side walls of the release holes.

## Description

### Field of the Invention

The present invention is related to microelectronic process technology. In particular it relates to Micro and Nano Electromechanical Systems (MEMS and NEMS) process technology. The present invention relates to a method for forming a hermetically sealed micro-cavity and its use in a process flow to provide the capping part of the device.

### State of the art.

Many MEMS require a hermetic encapsulation under vacuum or under a controlled atmosphere and pressure in order to ensure a good performance or an acceptable lifetime operation. The encapsulation has to be performed without the deposition of sealing material on the MEMS device, which can cause damage to the device. Several approaches are known for device encapsulation with zero-level packaging or wafer level packaging, whereby the package is designed and fabricated at the same time as the MEMS device.

In EP1433741 a zero-level packaging method is described based on closing an opening in a membrane using a reflow material, the opening being located above an underlying cavity in a substrate. The method comprises depositing an intermediate layer onto the membrane layer which narrows down the openings to be sealed. Next, a reflow layer is deposited on the intermediate layer under a first set of pressure and atmosphere conditions to further partially close the openings. Then, the reflow layer is reflowed under a second set of pressure and atmosphere conditions to close the openings. This method allows hermetic sealing of openings in a film at controllable atmosphere and pressure. When using this method, some material of the different deposited layers passes through the openings and this material is deposited on fragile MEMS, thereby affecting proper working of such devices.

In "Wafer level encapsulation technology for MEMS devices using an HF-permeable PECVD SiOC capping layer" MEMS2008 pp798-801, a zero-level packaging method is described based on the use of a porous layer to avoid deposition inside the cavity. The method comprises the deposition of a porous layer after the patterning of the release holes. This step is followed by a release step in order to get free the MEMS structure. Therefore, the porous layer will prevent the deposition inside the cavity of the next layers to seal this cavity.

In order to use such a method, the release holes are necessarily limited to the range of few micrometers to provide enough mechanical stiffness of this porous layer to withstand the process operations in the different tools. On the other hand, the definition of the isolation trenches in the capping part to define the electrical connections of the device requires larger openings to avoid parasitic capacitance between the different pads and cap. Due to the size of this opening, the porous layer will not survive the needed process steps (indeed during cleaning operations the surface of the wafer is exposed to liquid with several bars of pressure, ...) and especially the required metallization of the pads needed for the wirebonding step can not be done through a simple deposition due to the risk of shortcut. Indeed, the porous layer will be covered by this metallization providing a shortcut between the two parts at differential potential.

### Aims of the invention

The present invention aims to provide a method and devices which do not suffer from the drawbacks of the prior art methods and devices.

### Summary of the invention

The present invention is related to a method for sealing a cavity, preferably a cavity wherein a MEMS or NEMS device is located. According to the method, a membrane layer is deposited on top of a sacrificial layer, after which release holes are etched in the membrane layer and a release step is performed wherein at least a portion of the sacrificial layer is removed through the release holes, to thereby form the cavity. Before said release step, a narrowing layer is produced on the side walls of the release holes. The narrowing layer can be a sealing layer which seals off the release holes after a reflow step. Alternatively, the narrowing layer can be a layer that does not have a sealing function, but which is aimed only at narrowing the holes, so as to be able to seal off the holes without the danger of sealing or other material entering the cavity. The narrowing layer may be deposited by conformal deposition followed by an anisotropic etch, or by direct deposition on the side walls of the release holes. The term 'sealing layer' in the present context means a layer whose function it is within the method of the invention to seal off the release holes, either directly or after a reflow step. A 'non-sealing layer' is a layer which does not have this function in the method.

The invention is related to a method and devices as described in the appended claims. Features from the dependent claims may be combined with features of the independent claims and with features of other dependent claims as appropriate and not merely as explicitly set out in the claims.

The invention is thus related to a method for sealing a cavity, comprising the steps of :
- providing a substrate,
- depositing a sacrificial layer on said substrate,
- depositing a membrane layer on said sacrificial layer,
- etching at least one release hole in the membrane layer thereby exposing the sacrificial layer,
- forming a layer on the side walls of the release hole(s), thereby narrowing said holes, wherein said narrowing layer may or may not be a sealing layer,
- removing via the release hole(s) the sacrificial layer, so as to form a cavity,
- and :
   ○ if the narrowing layer is a sealing layer, closing the release holes by reflow of the sealing layer, or
   ○ if the narrowing layer is not a sealing layer, depositing a sealing layer on top of the membrane, and closing the release holes directly or by reflow of said sealing layer.

According to an embodiment, the step of forming a narrowing layer comprises :
- depositing a conformal layer on the membrane layer and on the side walls and bottom of the release hole(s),
- anisotropically etching the conformal layer, thereby leaving said conformal layer only on the side walls of the release hole(s).

According to another embodiment, the step of forming a narrowing layer comprises depositing selectively said sealing layer on the side walls of the release hole(s).

According to an embodiment, simultaneously with etching said release hole(s), the membrane layer is etched to form a cap structure above the location where said cavity is created and/or to form contact pads.

The method of the invention may further comprise the step of depositing a metal layer on the membrane layer.

Said sealing layer may be a metal or metal alloy layer. The sealing layer may be formed of a stack of layers. The sealing layer may comprise or consist of aluminium, germanium, gold or indium.

According to a preferred embodiment, said substrate comprises one or more MEMS or NEMS devices, and said step of removing the sacrificial layer is performed so as to form a cavity comprising one or more MEMS or NEMS devices.

According to an embodiment, said substrate is formed of a base substrate, an insulator layer on said base substrate, and a structural semiconductor layer comprising one or more MEMS or NEMS devices on said insulating layer, and wherein at least a portion of said insulating layer is removed together with the sacrificial layer, through the release holes, so as to form said cavity comprising one or more MEMS or NEMS devices.

The invention is equally related to a MEMS or NEMS device encapsulated in a cavity covered by a cap, said cap having a top surface and side walls, wherein release holes are present in said cap, said release holes being sealed by a portion of sealing material, wherein a layer of said sealing material is present on the side walls of said release holes.

According to an embodiment, a layer of said sealing material is present on the side walls of said cap, said layer having a portion on the lower rim of said side walls, said portion having a higher thickness than the rest of said layer, said portion extending downward from said rim.

A device of the invention may further comprise a metal layer on the top surface of said cap.

### Brief description of the figures

Figure 1 illustrates the steps of the method according to the first embodiment, wherein the narrowing layer is a sealing layer.

Figure 2 illustrates the steps of the method according to the second embodiment, wherein the narrowing layer is not a sealing layer.

Figure 3 illustrates a process flow for producing a MEMS device according the first embodiment of the method of the invention.

### Detailed description of the invention

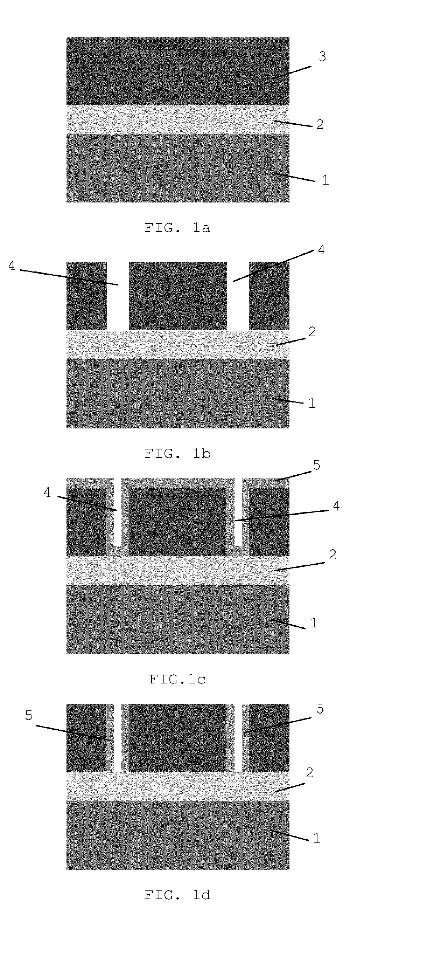

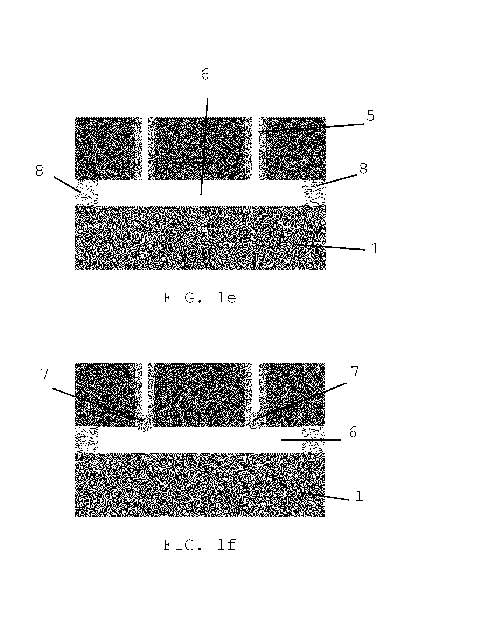

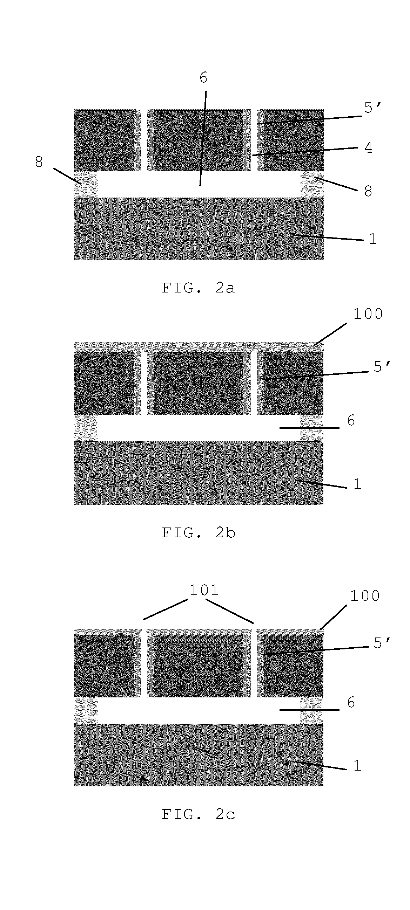

Figures 1 and 2 illustrate the basic method steps according to two embodiments of the invention. With reference to figures 1a to 1e, a substrate 1 is provided, which may be a semiconductor substrate with a MEMS or NEMS device on the surface. A sacrificial layer 2 is deposited on the surface of the substrate, and a membrane layer 3 is deposited on top of the sacrificial layer. The substrate may be a silicon wafer, the sacrificial layer a silicon oxide layer, the membrane layer could be Si or SiGe, preferably in a polycrystalline structure (i.e. a polysilicon layer or a polysilicon-germanium layer).

Release holes 4 are etched, for example by a dry etch process in combination with a known lithography step, in the membrane layer 3, stopping on the sacrificial layer 2. A narrowing layer 5 is deposited conformally. This means that the narrowing layer is deposited with substantially the same thickness on the entire exposed surface, including the side walls and bottom of the release holes 4. The steps shown in figures 1a to 1f illustrate the first embodiment, according to which the narrowing layer 5 is a sealing layer. The sealing layer material has a lower melting point than the membrane material. Preferably, the sealing layer is a metal or metal alloy layer. According to specific embodiments, the sealing layer comprises or consists of aluminium, germanium, gold or indium. The sealing layer can also be a silicon oxide layer or a silicon nitride layer. The material of the sealing layer can be chosen in such a way that reflow can be performed at different temperatures in the range 100°C-1100°C depending on the application. The sealing layer can be a single layer or it may comprise a stack of layers in order to form an alloy during reflow. In this way, by choosing the layers of which the stack is composed, the reflow temperature may be controlled within a given range. The reflow material may be chosen in such a way as to be able to perform an outgassing before reflow, at a temperature lower than the reflow temperature. An outgassing step is a known process step whereby residual vapour and gas is removed after a release step (see further).

In the next step of the method according to the embodiment of figure 1, the sealing layer 5 is etched anisotropically, preferably by a dry etch process, stopping on the membrane layer 3 and on the sacrificial layer 2. This means that the sealing layer remains only on the side walls of the release holes.

Then a portion of the sacrificial layer 2 is removed via the release holes 4, thereby forming a cavity 6. This step is also referred to as the release-step. The removal of the sacrificial layer may take place by a wet or dry etch of the sacrificial layer. An HF-based etch is preferred in the case of oxide used as the sacrificial layer. The use of Vapour HF (vHF) is preferred. According to a preferred embodiment, the substrate 1 comprises a MEMS or NEMS device and the cavity is formed so as to contain one or more of such devices.

In the embodiment shown, the release step removes a portion of the sacrificial layer 2, and the sidewalls of the cavity are formed by the remaining portion 8 of the sacrificial layer. In this case, the etch step must be stopped at the appropriate time so as to obtain the cavity 6. According to another embodiment, the sacrificial layer 2 may be surrounded by a structure such as a support frame for the membrane. In this case the totality of said sacrificial layer is removed in the release step. Preferably the material of the surrounding structure is such that a selective etch can be performed, which automatically stops when all of the sacrificial layer material has been removed.

As stated, an outgassing step may be performed after the release step. Then a reflow of the sealing layer 5 is done under a controlled atmosphere and pressure. The reflow step may be performed in a reflow oven as known in the art. Droplets 7 of sealing layer material are formed at the lower end of the release openings 4. However, droplets may equally be formed at the upper end or in between the ends. This may depend on the geometry of the openings 4 (e.g. slightly more narrow at one end compared to the other end). Deposition of the reflow material inside the cavity is not possible because the gravitational force is negligible compared to the capillary force at the microscale. For example, in order to ensure that the capillary forces are sufficient to obtain this effect, the diameter of the release holes may be about 1 micron, and the thickness of the sealing layer may be a few hundreds of nanometres.

According to a second embodiment illustrated in figures 2a to 2c, the narrowing layer is not a sealing layer. It is then preferably a layer 5' of the same material as the membrane layer, e.g. a polySiGe layer (although other suitable materials are possible). The steps of figures 1a to 1d are applicable without change to this embodiment, wherein the sealing layer 5 is replaced by a non-sealing narrowing layer 5'. Figure 2a shows the situation after the anistropic etch of the narrowing layer 5'. According to this embodiment, a sealing layer 100 is deposited on top of the membrane layer, either to directly close off the release holes (figure 2b) without a reflow step, or it may be deposited in a thickness suitable for forming a collar 101 around the edge of the release holes (figure 2c). A reflow step is then performed in order to close said collar. The latter steps illustrated in figures 2b and 2c are known as such in the art. The material of the sealing layer 100 may be any material known in the art to be suitable for this purpose (e.g. metal such as aluminium or gold, silicon oxide, ...). The second embodiment (narrowing layer is not a sealing layer) allows to narrow down release holes in a SiGe membrane layer of about 1micron in diameter to about 100nm or less, by depositing a SiGe narrowing layer 5'. This ensures that no sealing material drops into the released cavity during reflow of the sealing layer 100 (in the case of figure 2c). Also, it allows to apply a thin sealing layer 100, thereby preventing the problems related to thicker sealing layers (stress related delamination or leak path formation towards the cavity).

According to the first and second embodiment, instead of depositing a conformal layer followed by anisotropic etching, the narrowing layer 5/5' may be deposited directly on the side walls of the release holes 4 and only on said side walls, by a selective deposition technique (e.g. Atomic Layer Deposition ALD).

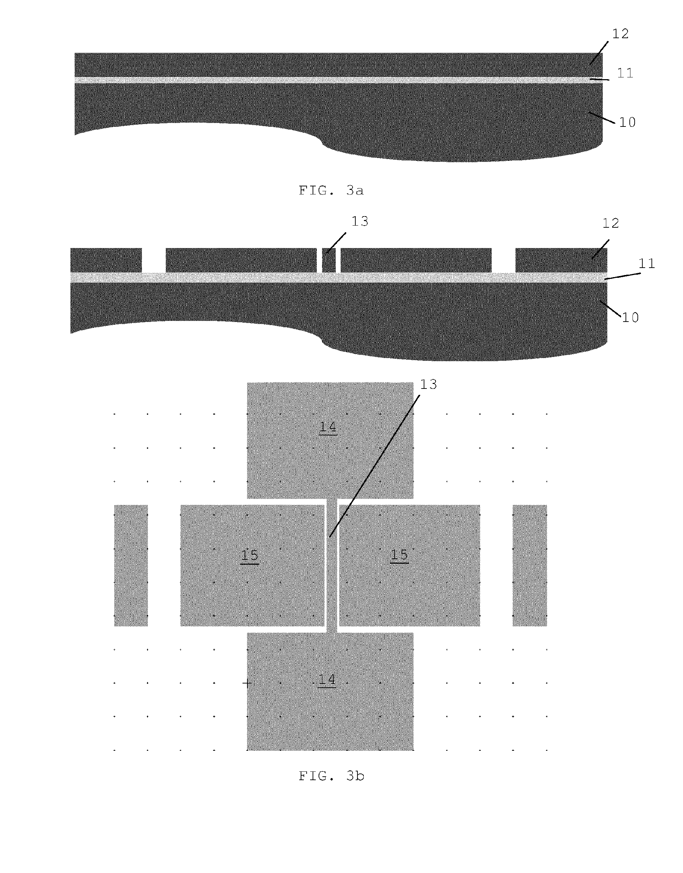

Advantageously, the method of the invention allows to etch away portions of the membrane layer simultaneously with etching the release holes 4, to thereby define an actual cap structure covering a MEMS device, and/or to define bonding pads for contacting the MEMS device. A process flow for producing a capped MEMS device in this way is shown in figures 3a to 3l.

Figure 3a shows a wafer consisting of a base substrate 10, an insulating layer 11 and a structural layer 12. The structural layer is a semiconductor layer which comprises one or more MEMS or NEMS type devices. The wafer of figure 3a may be produced from a semiconductor on insulator type wafer (SOI), e.g. silicon on insulator. The insulating layer 11 is of a material which can be etched during the release step (see further). The structural layer 12 is produced in the semiconductor layer of the SOI.

The structural layer 12 is etched to define a MEMS device 13 (fig. 3b). The etching step stops on the insulating layer 11. Figure 3b further shows a top view of the MEMS device 13 (by way of example, the shape of the MEMS can be different), illustrating the result of the etching step. The MEMS device in this example is a resonator which is a beam 13, arranged between mechanical anchor regions 14. Parts 15 are the RF port (I/O). The wafer as shown in figure 3b corresponds to the substrate 1 referred to in the appended claims. The method of the invention is applied on this wafer.

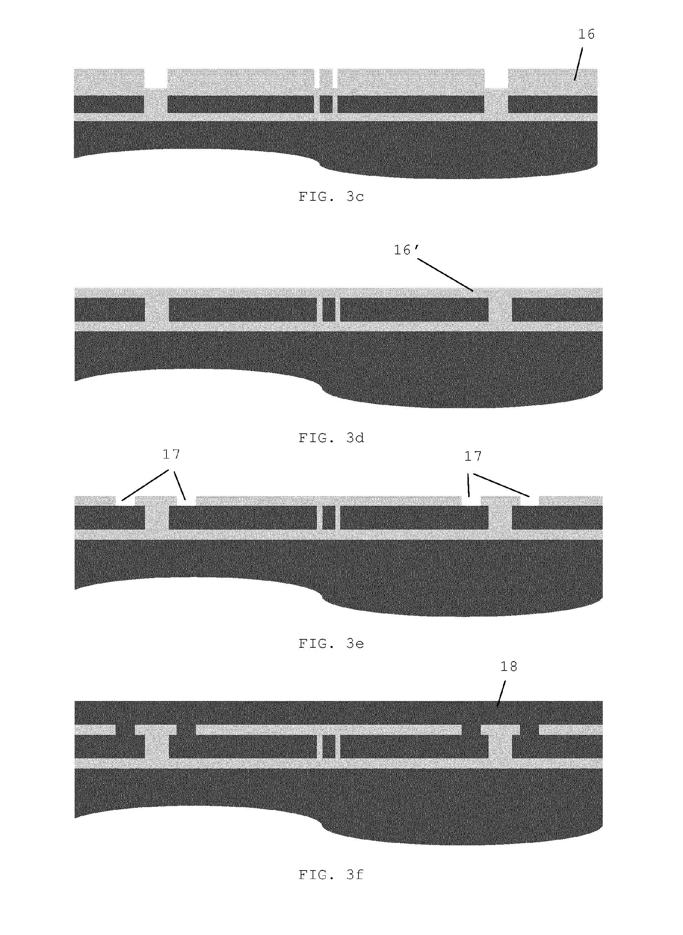

A sacrificial layer 16 is deposited on top of the patterned structural layer 12 (fig. 3c), thereby filling the area surrounding the MEMS device 13. The sacrificial layer 16 may be of the same material as the insulating layer 11, e.g. silicon oxide.

The sacrificial layer 16 is planarized using a known planarization technique, such as Chemical Mechanical polishing (CMP), see figure 3d, resulting in the planarized sacrificial layer 16'.

Openings 17 are etched in the second sacrificial layer16', stopping on the structural layer 12, in order to provide electrical feedthroughs (fig. 3e).

Then (fig. 3f) a membrane layer 18 is deposited, filling the openings 17, and forming a continuous layer on top of the structural layer 12 and sacrificial layer 16'.

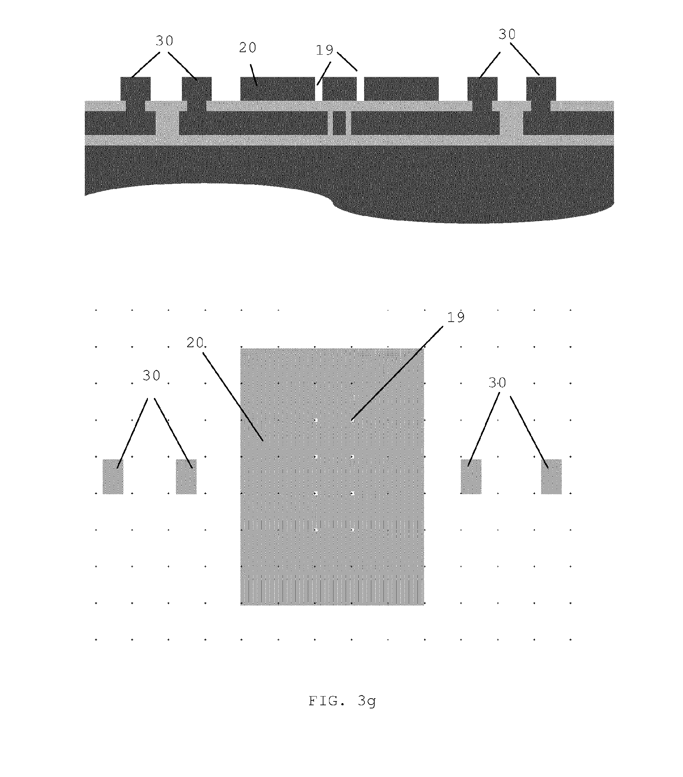

Then the membrane layer 18 is etched to form release holes 19 and to define the portion 20 of the membrane that will form the cap covering the MEMS device in the end (fig. 3g). Areas 30 of the membrane layer remain on top of the openings 17 in the sacrificial layer 16'. Said areas 30 will form contact pads for contacting the MEMS device 13. Figure 3g shows a top view of the result of the step of etching the membrane.

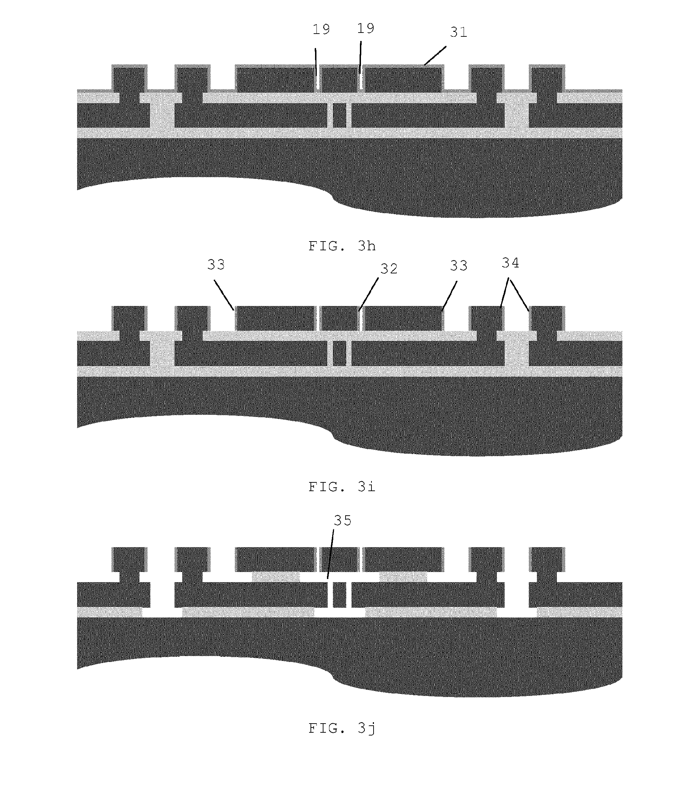

Then (fig. 3h), a sealing layer 31 is deposited conformally on the membrane and on the sacrificial layer 16', so that a sealing layer is present on the walls and bottom of the release holes 19, i.e. according to the first embodiment of the invention.

Then (fig. 3i), the sealing layer is etched back, stopping on the sacrificial layer 16', and leaving a layer 32 of sealing material on the side walls of the release holes, a layer 33 of sealing material on the side walls of the cap 20, and a layer 34 of sealing material on the side walls of the bond pads 30.

Then (fig. 3j) a release step is performed wherein the sacrificial layer 16' and the insulating layer 11 are partially removed, thereby forming a cavity 35 with the MEMS 13 inside said cavity. In this case therefore, the insulating layer 11 forms an additional sacrificial layer already present on the substrate when the step of depositing a sacrificial layer 16 according to the method of the invention is applied. The release step can be done by a wet or dry etch of the sacrificial layer, preferably an HF-based etch (preferably vapour HF) in the case of oxide used as the sacrificial layer.

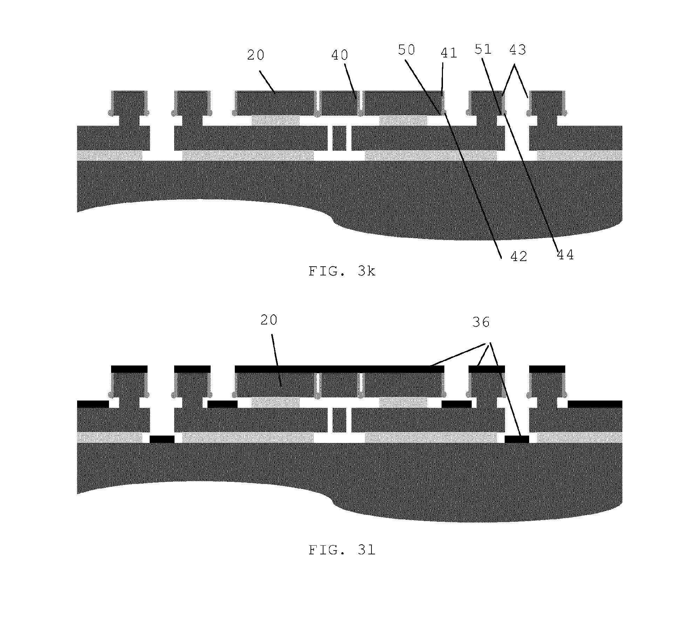

Then (fig. 3k) a reflow step is done : the substrate is heated up to a temperature above the melting point of the sealing layer 31, which is lower than the melting point of the membrane layer 18. The reflow of the sealing layer inside the release holes 19 seals off of these holes.

Then (fig. 3l) a metal layer 36 is deposited, to form the required metallization for the bond pads 30. This layer provides an additional sealing for the cavity 35.

The invention is equally related to a packaged MEMS or NEMS device obtainable by the method according to the first embodiment the invention (wherein the narrowing layer is a sealing layer). Characteristic to such a device, e.g. as seen in figure 3k or 3l is that the device is encapsulated in a cavity closed off by a membrane cap 20, having release holes 19 which are sealed by a portion of reflowed sealing material, wherein a layer 40 of said sealing material is present on the side walls of the release holes. When the release holes have been etched simultaneously with the etching of the membrane layer to define the cap 20 and the bonding pads 30, the side walls of the cap are equally covered by a layer 41 of sealing material, with a thicker portion 42 at the bottom, obtained by the reflow of the sealing material present on these side walls. The fact that the simultaneous etching has taken place is detectable by the fact that the thicker portion 42 extends downward with respect to the lower rim 50 of the cap's side wall. Likewise, on the side walls of the bond pads 30, a layer 43 of sealing material is present with a thickened portion 44 at the lower end, extending downward with respect to the lower rim 51 of the bond pads.

## Claims

1. A method for sealing a cavity, comprising the steps of :
• providing a substrate (1),
• depositing a sacrificial layer (2,16) on said substrate,
• depositing a membrane layer (3,18) on said sacrificial layer (2,16),
• etching at least one release hole (4,19) in the membrane layer thereby exposing the sacrificial layer (2),
• forming a layer (5, 5',31) on the side walls of the release hole(s) (4,19), thereby narrowing said holes, wherein said narrowing layer may or may not be a sealing layer,
• removing via the release hole(s) the sacrificial layer (2,16), so as to form a cavity (6,35),
• and :
o if the narrowing layer is a sealing layer (5,31), closing the release holes by reflow of the sealing layer, or
o if the narrowing layer (5') is not a sealing layer, depositing a sealing layer (100) on top of the membrane, and closing the release holes directly or by reflow of said sealing layer (100).

2. Method according to claim 1, wherein the step of forming a narrowing layer (5,31) comprises :
• depositing a conformal layer (5,31) on the membrane layer (3,18) and on the side walls and bottom of the release hole(s) (4,19),
• anisotropically etching the conformal layer (5,31), thereby leaving said conformal layer only on the side walls of the release hole(s) (4,19).

3. Method according to claim 1, wherein the step of forming a narrowing layer (5,31) comprises depositing selectively said narrowing layer on the side walls of the release hole(s) (4,19).

4. Method according to any one of claims 1 to 3, wherein the narrowing layer (5') is formed of the same material as the membrane layer (3).

5. Method according to any one of the preceding claims, wherein simultaneously with etching said release hole(s) (4,19), the membrane layer is etched to form a cap structure (20) above the location where said cavity is created and/or to form contact pads (30).

6. Method according to any one of claims 1 to 5, further comprising the step of depositing a metal layer (36) on the membrane layer (3,18).

7. Method according to any one of the preceding claims, wherein said sealing layer (5,31) is a metal or metal alloy layer.

8. Method according to any one of the preceding claims, wherein said sealing layer (5,31) is formed of a stack of layers.

9. Method according to claim 7 or 8, wherein said sealing layer (5,31) comprises or consists of aluminium, germanium, gold or indium.

10. Method according to any one of the preceding claims, wherein said substrate (1) comprises one or more MEMS or NEMS devices, and wherein said step of removing the sacrificial layer (2,16) is performed so as to form a cavity comprising one or more MEMS or NEMS devices.

11. Method according to any one of the preceding claims, wherein said substrate is formed of a base substrate (10), an insulator layer (11) on said base substrate (10), and a structural semiconductor layer (12) comprising one or more MEMS or NEMS devices (13) on said insulating layer, and wherein at least a portion of said insulating layer is removed together with the sacrificial layer (13), through the release holes (19), so as to form said cavity (35) comprising one or more MEMS or NEMS devices.

12. A MEMS or NEMS device encapsulated in a cavity (35) covered by a cap (20), said cap having a top surface and side walls, wherein release holes (19) are present in said cap, said release holes being sealed by a portion of sealing material, wherein a layer (40) of said sealing material is present on the side walls of said release holes.

13. A device according to claim 12, wherein a layer (41) of said sealing material is present on the side walls of said cap (20), said layer having a portion (42) on the lower rim (50) of said side walls, said portion having a higher thickness than the rest of said layer, said portion extending downward from said rim(50).

14. A device according to claim 12 or 13, further comprising a metal layer (36) on the top surface of said cap (20).
